# EUROPEAN PATENT SPECIFICATION

(11) **EP 4 110 025 B1**
(45) Date of publication and mention of the grant of the patent: **19.11.2025**
(21) Application number: 21180883.7
(22) Date of filing: 22.06.2021
(51) Int. Cl.: H05K 7/20, H02B 1/56, H02B 13/025

(54) **ENCLOSURE FOR ELECTRICAL EQUIPMENT**
GEHÄUSE FÜR ELEKTRISCHE AUSRÜSTUNG
ENCEINTE POUR ÉQUIPEMENT ÉLECTRIQUE

(43) Date of publication of application: 28.12.2022
(73) Proprietor: ABB Schweiz AG, 5400 Baden (CH)
(72) Inventor: Kärppä, Jaani, 00380 Helsinki (FI); Sääskilahti, Veli, 00380 Helsinki (FI); Nguyen, Tuan, 00380 Helsinki (FI)
(74) Representative: Kolster Oy Ab

(56) References cited:
- WO-A1-2019/207666
- WO-A1-2020/100183
- GB-A- 2 593 072
- US-A1- 2016 042 896

## Description

### FIELD

The invention relates to an enclosure for electrical equipment and to a method for cooling electrical equipment within an enclosure.

### BACKGROUND

Electrical equipment, such as electrical power equipment and/or electronic equipment may be provided with a suitable enclosure around the electrical equipment. An example of an enclosure for electrical equipment is an indoor or outdoor cabinet made of plastics and/or metal, which can be used to protect the contents from the environment and also to protect equipment users or operators from an electrical shock, for example.

Enclosures for electrical equipment may be provided with a flow of cooling air inside the enclosure for cooling heat generating components and elements of the electrical equipment located within said enclosure interior space. The flow of cooling air inside the enclosure may be suitably guided by means of one or more air guides such that e.g. the air flow is directed to area(s) where cooling is needed.

Enclosures for electrical equipment may also be provided with a pressure release device, such as an explosion vent or an explosion hatch, in order to relieve an excess pressure difference between the interior and the exterior of the enclosure and to avoid further damage to the enclosure and the surroundings thereof, for example. Such an excess pressure difference between the interior and the exterior of the enclosure could result from an electrical arc or fire, for example, within the enclosure which may cause a rapid pressure increase inside the enclosure.

Document WO 2019/207666 A1 discloses an example of a power conversion apparatus provided with a pressure release device. Document WO 2020/100183 A1 discloses an example of a gas insulation switchgear provided with a pressure discharge duct. Document US 2016/0042896 A1 discloses an example of an arc resistant system comprising pressure relief assemblies.

A problem related to such enclosure configuration is that in case of a situation, e.g. a fault situation, in which the pressure inside the enclosure starts to build up, and needs to be released out of the enclosure through the pressure release device, the one or more air guides within the enclosure may hinder the release of the pressure, which may in turn lead to damage to the equipment and also to the surroundings of the enclosure, for example.

### BRIEF DESCRIPTION

An object of the invention is thus to provide a method and an apparatus for implementing the method so as to overcome the above problem or at least to alleviate the problem. The objects of the invention are achieved by an enclosure for electrical equipment and a method for cooling electrical equipment within an enclosure which are characterized by what is stated in the independent claims. The preferred embodiments of the invention are disclosed in the dependent claims.

The invention is based on the idea of providing an air guide configured to allow a pressure built up within the enclosure to be released by the air guide towards the at least one pressure release device.

An advantage of the solution of the invention is that excessive pressure built up within the enclosure can be better released out of the enclosure in a more controlled manner.

### BRIEF DESCRIPTION OF THE DRAWINGS

In the following the invention will be described in greater detail by means of preferred embodiments with reference to the accompanying drawings, in which:
Figure 1 shows an enclosure according to an embodiment;
Figure 2 shows a cross-sectional view of an enclosure according to an embodiment;
Figure 3 shows a cross-sectional view of an enclosure according to an embodiment;
Figure 4 shows an air guide according to an embodiment, which is not covered by the subject-matter of the claims;
Figure 5 shows an air guide according to an embodiment, which is not covered by the subject-matter of the claims;
   and
Figure 6 shows an air guide according to an embodiment.

### DETAILED DESCRIPTION

The following embodiments are exemplary. Although the description may refer to "an", "one", or "some" embodiment(s) in several locations, this does not necessarily mean that each such reference is to the same embodiment(s), or that the feature only applies to a single embodiment, for example. Single features of different embodiments may also be combined to provide other embodiments. Generally, all terms and expressions used should be interpreted broadly and they are intended to illustrate, not to restrict, the embodiments. The figures only show components necessary for understanding the various embodiments. The number and/or shape of the various elements, and generally their implementation, could vary from the examples shown in the figures. The application of the various embodiments described herein is not limited to any specific system, but it can be used in connection with various electrical equipment and enclosures therefor.

An enclosure for electrical equipment comprises outer walls defining an enclosure interior space, at least one pressure release device in at least one of the outer walls of the enclosure configured to release an excess pressure from within the enclosure interior space to exterior of the enclosure, and air moving means configured to provide a flow of cooling air for cooling heat generating elements of the electrical equipment located within said enclosure interior space. The enclosure further comprises at least one air guide located within the enclosure interior space, wherein the air guide has at least a first state and a second state, wherein in the first state the air guide is configured to guide the flow of the cooling air, and wherein in the second state the air guide is configured to allow a pressure built up and exceeding a first predetermined limit within the enclosure interior space to be released by the air guide towards the at least one pressure release device. According to an embodiment, the at least one air guide is configured to allow the pressure built up and exceeding the first predetermined limit within the enclosure interior space to be released through and/or past the air guide towards the at least one pressure release device.

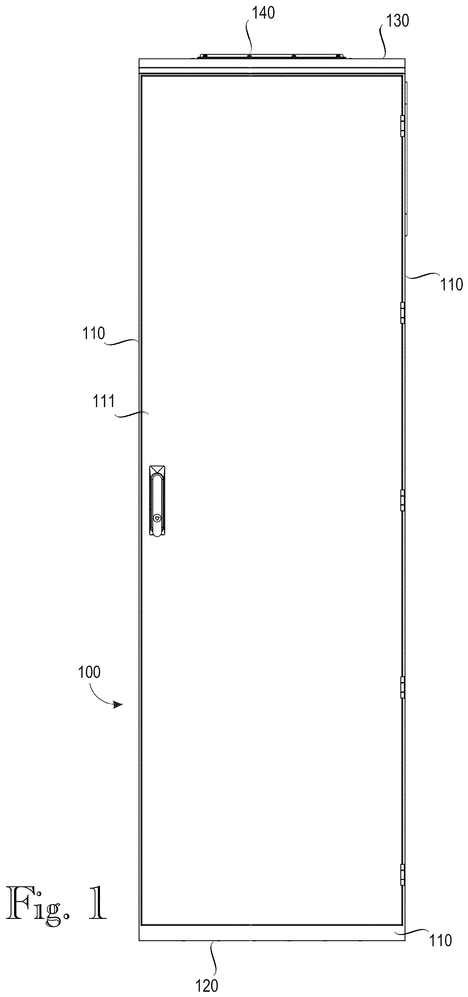

Figure 1 shows an enclosure 100 according to an embodiment. It should be noted that the shape and size of the enclosure 100 may vary from the example shown in the figure. The enclosure 100 may be used for housing electrical equipment, such as electrical power equipment and/or electronic equipment and/or other electrical equipment, for example. An example of such electrical power equipment includes an electrical converter device which may comprise at least one inverter and/or at least one rectifier and/or at least one frequency converter, for instance. The exemplary enclosure 100 comprises four side walls 110, a bottom wall 120, and a top wall 130, which define an enclosure interior space where electrical equipment may be housed. The number and shape of the walls 110, 120, 130 may vary from the example shown in the figure. One of the side walls 110 of the exemplary enclosure 100 comprises a door 111 providing access to the enclosure interior space. The walls 110, 120, 130 may comprise one or more elements made of metal, such as sheet metal, or plastic materials, for example. The exemplary enclosure 100 further comprises at least one pressure release device 140. In the example, the pressure release device 140 is provided in the top wall 130 but could be located in a side wall 110 instead, for example. The at least one pressure release device 140 may be an explosion vent, an explosion hatch, or a rupture panel or generally any such device capable of releasing excessive pressure from within the enclosure interior space of the enclosure 100.

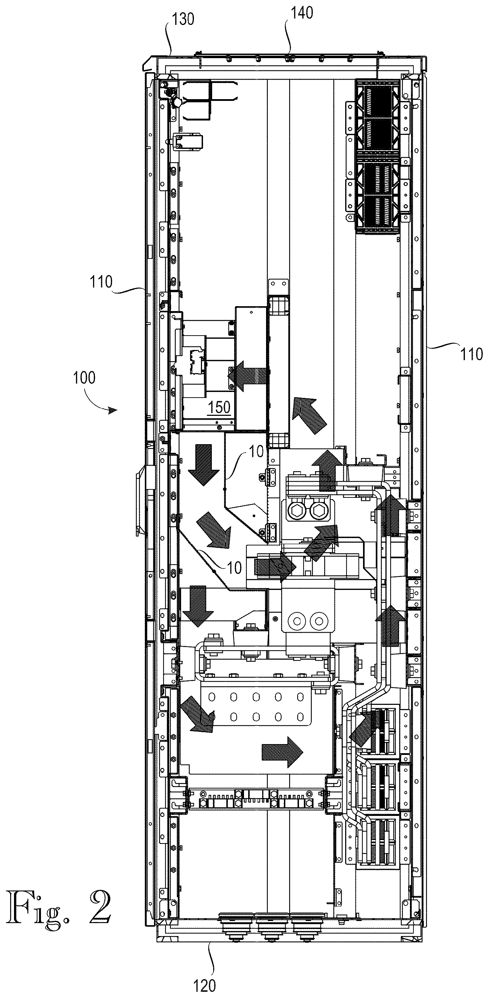

Figure 2 shows a cross-sectional view of the enclosure 100 according to an embodiment. The exemplary enclosure 100 shown in Figure 2 houses electrical equipment related to an electrical converter device, i.e. various elements thereof, some of which are shown for illustrative purposes in the figure. Figure 2 illustrates a normal situation during an operation of the electrical equipment located within the enclosure 100. In the example the enclosure 100 comprises air moving means 150 configured to provide a flow of cooling air for cooling heat generating elements of the electrical equipment located within the interior space of the enclosure 100. Generally, such air moving means 150 may comprise one or more fans located inside or outside of the interior space of the enclosure 100, for example. In the simplified example of Figure 2, the arrows show two exemplary main paths, an inner one and an outer one, of cooling air circulation within the interior space of the enclosure 100 provided by the air moving means 150. The cooling air may be circulated essentially continuously during the operation of the electrical equipment located within the interior space of the enclosure 100 or e.g. at predetermined times, and/or in response to a temperature of the interior space of the enclosure 100 and/or of the electrical equipment therein exceeding a predetermined threshold temperature, for example. Along the inner circulation path of the illustrated example there are two air guides 10, which are, in their first state, configured to guide the flow of the cooling air as illustrated. Term air guide (or air deflector) may herein refer to any suitable element or device that may be used for guiding an air flow in a desired manner. Such an air guide 10 may comprise one or more flat and/or curved panels or similar elements, for example. Generally, the shape and size of the air guide 10 may vary and may be determined by the characteristics of the system in which it is used in for guiding the air flow, for instance. The one or more air guides 10 may form or be part of one or more air ducts. The one or more air guides 10 may be integral parts of the structure of the enclosure 100 or separate parts fastened to the enclosure 100 or to the electrical equipment located within the enclosure 100, for instance. The one or more air guides 10 may be made of metal, such as sheet metal, and/or plastic and/or composite materials, for example. The one or more air guides 10, or any elements thereof, may be manufactured by any suitable or applicable manufacturing method, such as casting, stamping or extrusion, or any combination thereof, for example.

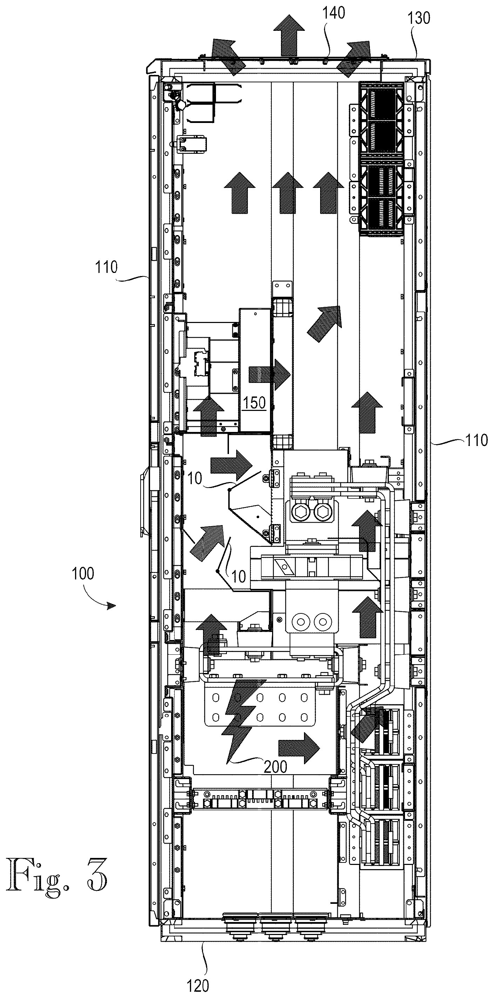

Figure 3 shows a cross-sectional view of the enclosure 100 according to an embodiment. Figure 3 illustrates a situation during an operation of the electrical equipment located within the enclosure 100 where a fault 200 has occurred and is causing pressure build-up, i.e. an increase of the pressure, within the interior space of the enclosure 100. An example of such a fault 200 is an electric arc but the fault 200 may be any fault event causing such pressure build-up. The pressure build-up in the example is initially local around the fault 200 location but eventually any local pressure difference(s) within the interior space of the enclosure 100 start to equalize and also when the pressure within the interior space of the enclosure 100 experienced by the at least one pressure release device 140 exceeds the pressure limit of the pressure release device 140, the pressure release device 140 allows the pressure within the interior space of the enclosure 100 to be released to the exterior of the enclosure 100. This is illustrated by the arrows in Figure 3 showing the movement of air and possibly also other gases, which may be formed by the fault 200. Thus, as illustrated, the excess pressure initially caused by the fault 200 is released out of the interior space of the enclosure 100 via the pressure release device 140. In this situation, the exemplary two air guides 10 are in their second state, wherein they are configured to allow the pressure built up and exceeding a first predetermined limit within the enclosure interior space to be released by the air guides 10 towards the at least one pressure release device 140. In other words, the air guides 10 in the example shift from their normal position (first state) to such a position that the pressure generated by the fault 200 can be released towards the pressure release device 140. According to an embodiment, the at least one air guide 10 may be configured to allow the pressure built up and exceeding the first predetermined limit within the enclosure interior space to be released through and/or past the air guide 10 towards the at least one pressure release device 140. Consequently, the air guide 10 may e.g. open up such that the pressure is released through it and/or the air guide 10 may e.g. move aside or away such that the pressure is released by essentially bypassing the air guide 10.

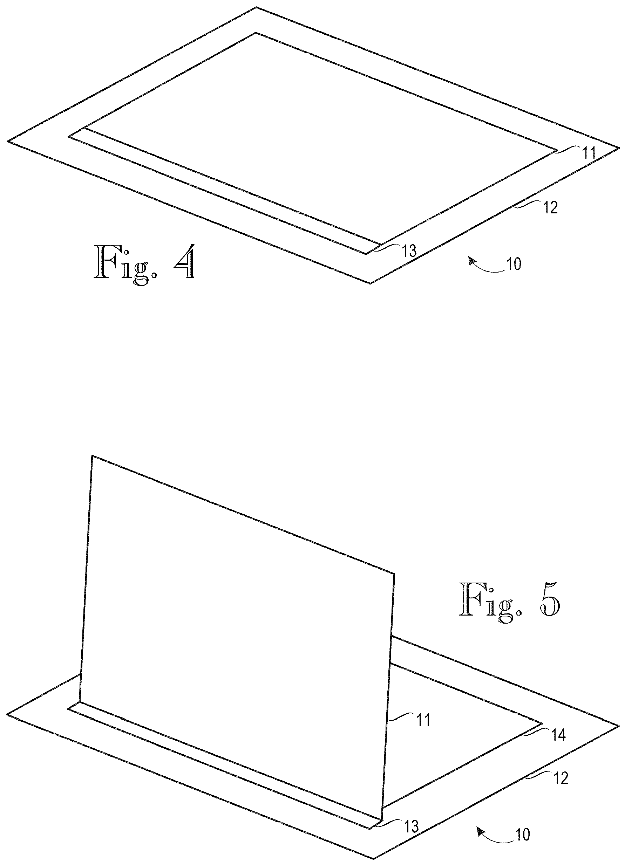

Figure 4 shows an air guide 10 according to an embodiment, which is not covered by the subject-matter of the claims.

In the figure the air guide is shown in its first state. Figure 5 shows the exemplary air guide 10 in its second state. The at least one air guide 10 is configured to move from the first state into the second state in response to a pressure in a first side (i.e. the lower side in Figures 4 and 5) of the air guide 10 exceeding a pressure in a second side (i.e. the upper side in Figures 4 and 5) of the air guide 10 by at least the first predetermined limit. Consequently, the operation of the air guide 10 is based on a pressure difference between the first side and the second side of the air guide 10. **The** at least one air guide 10 comprises a cover part 11, which is configured to cover an opening 14 in the first state of the air guide 10, and configured to be removed (at least partly) from the opening 14 in the second state of the air guide 10. The opening 14 may be part of the structure of the air guide 10 itself or provided in another structure within the enclosure 100. **The** at least one air guide 10 may comprise a frame part 12 provided with said opening 14 therethrough, wherein the cover part 11 is connected to the frame part 12. The cover part 11 may be pivotably connected to the frame part 12. This may be implemented by means of suitable hinge or hinges 13, for example. According to another embodiment, the cover part 11 may be integrally formed with the frame part 12. In this case the hinge 13 could be implemented by suitable thinning of the material, for example. According to an embodiment, whether integrally formed with the frame part 12 or not, the cover part 11 may comprise or be made of flexible material which enables the cover part 11 to flex under pressure. According to an embodiment, when the cover part 11 is pivotably connected to the frame part 12, as in the examples of Figures 4 and 5, the cover part 11 may be configured to return to the first state thereof by itself after the pressure difference between the first side and the second side of the air guide 10 goes below the first predetermined limit. This can be achieved by using e.g. a suitable spring member or an elastic member, e.g. in connection with the possible hinge 13, or as a separate element, which can return the cover part 11 to the first state thereof. Alternatively, the cover part 11 may be manually set back to its first state after moving away from the first state thereof. According to another embodiment, the cover part 11 may be releasably connected or connectable to the frame part 12. According to an embodiment, the cover part 11 may be configured to cover the opening 14 partly or completely in the first state of the air guide. Moreover, the cover part 11 may be configured to cover the opening 14 in a sealed or in a non-sealed manner, for example. The cover part 11 may comprise one or more portions or elements. In a similar manner, the opening 14 may consist of a plurality of subopenings, for example.

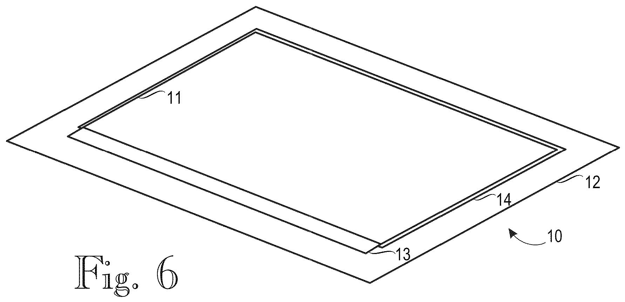

The at least one air guide 10 has a third state, wherein the air guide 10 is configured to move from the first state into the third state in response to the pressure in the second side of the air guide 10 exceeding the pressure in the first side of the air guide 10 by at least a second predetermined limit. According to an embodiment, the at least one air guide 10 may thus comprise a cover part 11, which is configured to cover an opening 14 in the first state of the air guide, and configured to be removed from the opening 14 in the second and third states of the air guide 10. Figure 6 shows an example of this embodiment. In the configuration of the air guide 10 shown in Figure 6, the cover part 11 can turn both upwards, i.e. to the second state of the air guide, and downwards, i.e. to the third state of the air guide 10. This differs from the example shown in Figures 4 and 5 in which the cover part 11 is prevented from turning downwards by the frame part 12, which is not covered by the subject-matter of the claims. Consequently, in the configuration of the air guide 10 shown in Figure 6, the cover part 11 can be configured to turn upwards, i.e. to the second state of the air guide, in response to the pressure in the first side (i.e. the lower side in Figure 6) of the air guide 10 exceeding the pressure in the second side (i.e. the upper side in Figure 6) of the air guide 10 by at least the first predetermined limit. And moreover, the cover part 11 can be configured to turn downwards, i.e. to the third state of the air guide 10, in response to the pressure in the second side (i.e. the upper side in Figure 6) of the air guide 10 exceeding the pressure in the first side (i.e. the lower side in Figure 6) of the air guide 10 by at least the second predetermined limit. Thus, the exemplary structure shown in Figure 6 enables the air guide 10 to allow the pressure to be released in either of the two directions through the opening 14 depending on which side of the air guide 10 the pressure build-up occurs.

According to an embodiment, the at least one air guide 10 could also be implemented, at least partly, as a breakable structure, such as one or more rupture panels or the like, such that the structure breaks upon the pressure difference between its two opposite side exceeding the first predetermined limit, i.e. the air guide thus shifts from the first state to the second state thereof, and consequently also allows the pressure built up to be released by the air guide 10 towards the at least one pressure release device.

According to an embodiment, in the above embodiments, the first predetermined limit and the second predetermined limit are preferably selected such that the air guide 10 during the normal operation thereof stays in its first state, i.e. essentially does not move away from the first state thereof, e.g. due to the pressure differences possibly occurring because of the normal circulation of the cooling air caused by the air moving means 150, for example. Moreover, the first predetermined limit and the second predetermined limit are preferably further selected such that the air guide 10 during a pressure build-up causing situation, such as a fault situation, nevertheless can shift swiftly enough from the first state to the second state, or to the third state, thereof to allow the pressure built up to be released by the air guide 10 towards the at least one pressure release device 140.

According to an embodiment, the number of air guides 10 according to any one of the above embodiments in the enclosure 100 can vary. Their position within the enclosure 100 is preferably predetermined such that they allow the pressure built up to be released by the air guide 10 towards the at least one pressure release device 140. The enclosure 100, and the electric equipment housed therein, may comprise one or more areas or points in which the occurrence or generation of a fault or another pressure build-up causing phenomenon is probable and/or possible, and any such areas or points may be taken into account when determining suitable locations for an air guide(s) 10 according to any of the embodiments described herein, and/or positions thereof. As an example, electric arc faults may occur between non-isolated busbars possibly included in such equipment within the enclosure 100.

According to an embodiment, a method for cooling electrical equipment within an enclosure 100, according to any one of the embodiments described herein, comprises providing, by air moving means 150, a flow of cooling air for cooling heat generating elements of the electrical equipment located within the enclosure interior space and guiding, by at least one air guide 10 located within the enclosure interior space, the flow of the cooling air within the enclosure interior space. The at least one air guide 10 may be provided according to any one of the embodiments described herein. The method further comprises, in response to a pressure difference between one side of the at least one air guide and another side of the at least one air guide 10 exceeding a predetermined limit, allowing the pressure difference to be released from a higher pressure to a lower pressure by the air guide 10 towards the at least one pressure release device 140.

It will be obvious to a person skilled in the art that, as the technology advances, the inventive concept can be implemented in various ways. The invention and its embodiments are not limited to the examples described above but may vary within the scope of the claims.

## Claims

1. An enclosure for electrical equipment, the enclosure (100) comprising:
outer walls (110, 120, 130) defining an enclosure interior space;
at least one pressure release device (140) in at least one of the outer walls (110, 120, 130) of the enclosure (100) configured to release an excess pressure from within the enclosure interior space to exterior of the enclosure (100);
air moving means (150) configured to provide a flow of cooling air for cooling heat generating elements of the electrical equipment located within said enclosure interior space; and
at least one air guide (10) located within the enclosure interior space, wherein the air guide (10) has at least a first state and a second state, wherein in the first state the air guide (10) is configured to guide the flow of the cooling air, and wherein in the second state the air guide (10) is configured to allow a pressure built up and exceeding a first predetermined limit within the enclosure interior space to be released by the air guide towards the at least one pressure release device (140), wherein the at least one air guide (10) is configured to move from the first state into the second state in response to a pressure in a first side of the air guide exceeding a pressure in the second side of the air guide by at least the first predetermined limit, **characterized,**
**in that**
the at least one air guide (10) has a third state, wherein the air guide (10) is configured to move from the first state into the third state in response to the pressure in the second side of the air guide exceeding the pressure in the first side of the air guide by at least a second predetermined limit.

2. An enclosure as claimed in claim 1, wherein the at least one air guide (10) is configured to allow the pressure built up and exceeding the first predetermined limit within the enclosure interior space to be released through and/or past the air guide towards the at least one pressure release device (140).

3. An enclosure as claimed in claim 1, wherein the at least one air guide (10) comprises a cover part (11), which is configured to cover an opening (14) in the first state of the air guide, and configured to be removed from the opening (14) in the second and third states of the air guide.

4. An enclosure as claimed in claim 3, wherein the at least one air guide (10) comprises a frame part (12) provided with said opening (14) therethrough, wherein the cover part (11) is connected to the frame part (12).

5. An enclosure as claimed in claim 4, wherein the cover part (11) is pivotably connected to the frame part (12).

6. An enclosure as claimed in claim 4 or 5, wherein the cover part (11) is integrally formed with the frame part (12).

7. An enclosure as claimed in claim 4, wherein the cover part (11) is releasably connected to the frame part (12).

8. An enclosure as claimed in any one of claims 1 to 7, wherein the air moving means (150) comprise at least one fan.

9. An electrical converter device comprising an enclosure as claimed in any one of claims 1 to 8.

10. An electrical converter device as claimed in claim 9, wherein the electrical converter device comprises at least one inverter and/or at least one rectifier and/or at least one frequency converter.

11. A method for cooling electrical equipment within an enclosure, the enclosure (100) comprising outer walls (110, 120, 130) defining an enclosure interior space, and at least one pressure release device (140) in at least one of the outer walls (110, 120, 130) of the enclosure configured to release an excess pressure from within the enclosure interior space to exterior of the enclosure (100), the method comprising:
providing, by air moving means (150), a flow of cooling air for cooling heat generating elements of the electrical equipment located within said enclosure interior space;
guiding, by at least one air guide (10) located within the enclosure interior space, the flow of the cooling air within the enclosure interior space in a first state of the at least one air guide (10); and
in response to a pressure difference between one side of the at least one air guide (10) and another side of the at least one air guide (10) exceeding a predetermined limit, allowing the pressure difference to be released from a higher pressure to a lower pressure by the air guide towards the at least one pressure release device (140) in a second state of the at least one air guide (10),
wherein the at least one air guide (10) is configured to move from the first state into the second state in response to a pressure in a first side of the air guide exceeding a pressure in the second side of the air guide by at least the first predetermined limit, and wherein the at least one air guide (10) has a third state, wherein the air guide (10) is configured to move from the first state into the third state in response to the pressure in the second side of the air guide exceeding the pressure in the first side of the air guide by at least a second predetermined limit.

12. A method as claimed in claim 11, wherein the allowing of the pressure difference to be released from the higher pressure to the lower pressure by the air guide (10) towards the at least one pressure release device (140) comprises allowing the pressure difference to be released from the higher pressure to the lower pressure through and/or past the air guide (10) towards the at least one pressure release device (140).

## Patentansprüche

1. Gehäuse für elektrische Geräte, wobei das Gehäuse (100) umfasst:
Außenwände (110, 120, 130), die einen Gehäuseinnenraum definieren;
mindestens eine Druckabbauvorrichtung (140) in mindestens einer der Außenwände (110, 120, 130) des Gehäuses (100), die so konfiguriert ist, dass sie einen Überdruck aus dem Gehäuseinnenraum nach außerhalb des Gehäuses (100) abbaut;
Luftbewegungsmittel (150), die so konfiguriert sind, dass sie einen Kühlluftstrom zum Kühlen wärmeerzeugender Elemente der elektrischen Geräte bereitstellen, die sich innerhalb des Gehäuseinnenraums befinden; und
mindestens eine Luftführung (10), die sich innerhalb des Gehäuseinnenraums befindet, wobei die Luftführung (10) zumindest einen ersten Zustand und einen zweiten Zustand aufweist, wobei die Luftführung (10) im ersten Zustand so konfiguriert ist, dass sie den Kühlluftstrom leitet, und wobei die Luftführung (10) im zweiten Zustand so konfiguriert ist, dass ein aufgebauter Druck, der einen ersten vorbestimmten Grenzwert innerhalb des Gehäuseinnenraums überschreitet, durch die Luftführung in Richtung der mindestens einen Druckabbauvorrichtung (140) abgebaut werden kann, wobei die mindestens eine Luftführung (10) so konfiguriert ist, dass sie sich vom ersten Zustand in den zweiten Zustand bewegt, wenn ein Druck auf einer ersten Seite der Luftführung einen Druck auf der zweiten Seite der Luftführung um zumindest den ersten vorbestimmten Grenzwert überschreitet, **dadurch gekennzeichnet, dass** die mindestens eine Luftführung (10) einen dritten Zustand aufweist, wobei die Luftführung (10) so konfiguriert ist, dass sie sich vom ersten Zustand in den dritten Zustand bewegt, wenn der Druck auf der zweiten Seite der Luftführung den Druck auf der ersten Seite der Luftführung um zumindest einen zweiten vorbestimmten Grenzwert überschreitet.

2. Gehäuse nach Anspruch 1, wobei die mindestens eine Luftführung (10) so konfiguriert ist, dass der im Gehäuseinnenraum aufgebaute und den ersten vorbestimmten Grenzwert überschreitende Druck durch die und/oder an der Luftführung vorbei in Richtung der mindestens einen Druckabbauvorrichtung (140) abgebaut werden kann.

3. Gehäuse nach Anspruch 1, wobei die mindestens eine Luftführung (10) ein Abdeckteil (11) umfasst, das so konfiguriert ist, dass es im ersten Zustand der Luftführung eine Öffnung (14) abdeckt, und so konfiguriert ist, dass es im zweiten und dritten Zustand der Luftführung von der Öffnung (14) entfernt werden kann.

4. Gehäuse nach Anspruch 3, wobei die mindestens eine Luftführung (10) ein Rahmenteil (12) umfasst, das mit der dort hindurchgehenden Öffnung (14) versehen ist, wobei das Abdeckteil (11) mit dem Rahmenteil (12) verbunden ist.

5. Gehäuse nach Anspruch 4, wobei das Abdeckteil (11) schwenkbar mit dem Rahmenteil (12) verbunden ist.

6. Gehäuse nach Anspruch 4 oder 5, wobei das Abdeckteil (11) integral mit dem Rahmenteil (12) ausgebildet ist.

7. Gehäuse nach Anspruch 4, wobei das Abdeckteil (11) lösbar mit dem Rahmenteil (12) verbunden ist.

8. Gehäuse nach einem der Ansprüche 1 bis 7, wobei die Luftbewegungsmittel (150) mindestens ein Gebläse umfassen.

9. Elektrische Wandlervorrichtung, umfassend ein Gehäuse nach einem der Ansprüche 1 bis 8.

10. Elektrische Wandlervorrichtung nach Anspruch 9, wobei die elektrische Wandlervorrichtung mindestens einen Wechselrichter und/oder mindestens einen Gleichrichter und/oder mindestens einen Frequenzwandler umfasst.

11. Verfahren zum Kühlen elektrischer Geräte innerhalb eines Gehäuses, wobei das Gehäuse (100) Außenwände (110, 120, 130), die einen Gehäuseinnenraum definieren, und mindestens eine Druckabbauvorrichtung (140) in mindestens einer der Außenwände (110, 120, 130) des Gehäuses umfasst, die so konfiguriert ist, dass sie einen Überdruck aus dem Gehäuseinnenraum nach außerhalb des Gehäuses (100) abbaut, wobei das Verfahren umfasst:
Bereitstellen eines Kühlluftstroms durch Luftbewegungsmittel (150) zum Kühlen wärmeerzeugender Elemente der elektrischen Geräte, die sich innerhalb des Gehäuseinnenraums befinden;
Leiten des Kühlluftstroms innerhalb des Gehäuseinnenraums durch mindestens eine Luftführung (10), die sich innerhalb des Gehäuseinnenraums befindet, in einem ersten Zustand der mindestens einen Luftführung (10); und
wenn eine Druckdifferenz zwischen einer Seite der mindestens einen Luftführung (10) und einer anderen Seite der mindestens einen Luftführung (10) einen vorbestimmten Grenzwert überschreitet, Ermöglichen, dass die Druckdifferenz von einem höheren Druck auf einen niedrigeren Druck durch die Luftführung in Richtung der mindestens einen Druckabbauvorrichtung (140) in einem zweiten Zustand der mindestens einen Luftführung (10) abgebaut wird,
wobei die mindestens eine Luftführung (10) so konfiguriert ist, dass sie sich vom ersten in den zweiten Zustand bewegt, wenn ein Druck auf einer ersten Seite der Luftführung einen Druck auf der zweiten Seite der Luftführung um zumindest den ersten vorbestimmten Grenzwert überschreitet, und wobei die mindestens eine Luftführung (10) einen dritten Zustand aufweist, wobei die Luftführung (10) so konfiguriert ist, dass sie sich vom ersten Zustand in den dritten Zustand bewegt, wenn der Druck auf der zweiten Seite der Luftführung den Druck auf der ersten Seite der Luftführung um zumindest einen zweiten vorbestimmten Grenzwert überschreitet.

12. Verfahren nach Anspruch 11, wobei das Ermöglichen eines Abbaus der Druckdifferenz vom höheren Druck auf den niedrigeren Druck durch die Luftführung (10) in Richtung der mindestens einen Druckabbauvorrichtung (140) Ermöglichen eines Abbaus der Druckdifferenz vom höheren Druck auf den niedrigeren Druck durch die und/oder an der Luftführung (10) vorbei in Richtung der mindestens einen Druckabbauvorrichtung (140) umfasst.

## Revendications

1. Enceinte pour équipement électrique, l'enceinte (100) comprenant :
des parois externes (110, 120, 130) définissant un espace intérieur d'enceinte ;
au moins un dispositif de relâchement de pression (140) dans au moins l'une des parois externes (110, 120, 130) de l'enceinte (100) configuré pour relâcher un excès de pression de l'intérieur de l'espace intérieur d'enceinte vers l'extérieur de l'enceinte (100) ;
des moyens de déplacement d'air (150) configurés pour fournir un écoulement d'air de refroidissement pour refroidir des éléments générant de la chaleur de l'équipement électrique situés à l'intérieur dudit espace intérieur d'enceinte ; et
au moins un guide d'air (10) situé à l'intérieur de l'espace intérieur d'enceinte, dans laquelle le guide d'air (10) a au moins un premier état et un deuxième état, dans laquelle dans le premier état, le guide d'air (10) est configuré pour guider l'écoulement de l'air de refroidissement, et dans laquelle dans le deuxième état, le guide d'air (10) est configuré pour permettre à une pression accumulée et dépassant une première limite prédéterminée à l'intérieur de l'espace intérieur d'enceinte d'être relâchée par le guide d'air vers l'au moins un dispositif de relâchement de pression (140), dans laquelle l'au moins un guide d'air (10) est configuré pour passer du premier état au deuxième état en réponse au dépassement par une pression dans un premier côté du guide d'air d'une pression dans le second côté du guide d'air d'au moins la première limite prédéterminée, **caractérisée en ce que** l'au moins un guide d'air (10) a un troisième état, dans laquelle le guide d'air (10) est configuré pour passer du premier état au troisième état en réponse au dépassement par la pression dans le second côté du guide d'air de la pression dans le premier côté du guide d'air d'au moins une seconde limite prédéterminée.

2. Enceinte selon la revendication 1, dans laquelle l'au moins un guide d'air (10) est configuré pour permettre à la pression accumulée et dépassant la première limite prédéterminée à l'intérieur de l'espace intérieur d'enceinte d'être relâchée par l'intermédiaire et/ou au-delà du guide d'air vers l'au moins un dispositif de relâchement de pression (140).

3. Enceinte selon la revendication 1, dans laquelle l'au moins un guide d'air (10) comprend une partie de cache (11), qui est configurée pour couvrir une ouverture (14) dans le premier état du guide d'air, et configurée pour être retirée de l'ouverture (14) dans les deuxième et troisième états du guide d'air.

4. Enceinte selon la revendication 3, dans laquelle l'au moins un guide d'air (10) comprend une partie de cadre (12) pourvue de ladite ouverture (14) à travers celle-ci, dans laquelle la partie de cache (11) est reliée à la partie de cadre (12).

5. Enceinte selon la revendication 4, dans laquelle la partie de cache (11) est reliée de manière pivotante à la partie de cadre (12).

6. Enceinte selon la revendication 4 ou 5, dans laquelle la partie de cache (11) est formée d'un seul tenant avec la partie de cadre (12).

7. Enceinte selon la revendication 4, dans laquelle la partie de cache (11) est reliée de manière amovible à la partie de cadre (12).

8. Enceinte selon l'une quelconque des revendications 1 à 7, dans laquelle les moyens de déplacement d'air (150) comprennent au moins un ventilateur.

9. Dispositif convertisseur électrique comprenant une enceinte selon l'une quelconque des revendications 1 à 8.

10. Dispositif convertisseur électrique selon la revendication 9, dans lequel le dispositif convertisseur électrique comprend au moins un onduleur et/ou au moins un redresseur et/ou au moins un convertisseur de fréquence.

11. Procédé de refroidissement d'équipement électrique à l'intérieur d'une enceinte, l'enceinte (100) comprenant des parois externes (110, 120, 130) définissant un espace intérieur d'enceinte, et au moins un dispositif de relâchement de pression (140) dans au moins l'une des parois externes (110, 120, 130) de l'enceinte configuré pour relâcher un excès de pression de l'intérieur de l'espace intérieur d'enceinte vers l'extérieur de l'enceinte (100), le procédé comprenant :
la fourniture, par des moyens de déplacement d'air (150), d'un écoulement d'air de refroidissement pour refroidir des éléments générant de la chaleur de l'équipement électrique situés à l'intérieur dudit espace intérieur d'enceinte ;
le guidage, par au moins un guide d'air (10) situé à l'intérieur de l'espace intérieur d'enceinte, de l'écoulement de l'air de refroidissement à l'intérieur de l'espace intérieur d'enceinte dans un premier état de l'au moins un guide d'air (10) ; et
en réponse au dépassement par une différence de pression entre un côté de l'au moins un guide d'air (10) et un autre côté de l'au moins un guide d'air (10) d'une limite prédéterminée, le fait de permettre à la différence de pression d'être relâchée d'une pression supérieure à une pression inférieure par le guide d'air vers l'au moins un dispositif de relâchement de pression (140) dans un deuxième état de l'au moins un guide d'air (10),
dans lequel l'au moins un guide d'air (10) est configuré pour passer du premier état au deuxième état en réponse au dépassement par une pression dans un premier côté du guide d'air d'une pression dans le second côté du guide d'air d'au moins la première limite prédéterminée, et dans lequel l'au moins un guide d'air (10) a un troisième état, dans lequel le guide d'air (10) est configuré pour passer du premier état au troisième état en réponse au dépassement par la pression dans le second côté du guide d'air de la pression dans le premier côté du guide d'air d'au moins une seconde limite prédéterminée.

12. Procédé selon la revendication 11, dans lequel le fait de permettre à la différence de pression d'être relâchée de la pression supérieure à la pression inférieure par le guide d'air (10) vers l'au moins un dispositif de relâchement de pression (140) comprend le fait de permettre à la différence de pression d'être relâchée de la pression supérieure à la pression inférieure par l'intermédiaire et/ou au-delà du guide d'air (10) vers l'au moins un dispositif de relâchement de pression (140).
